# EUROPEAN PATENT SPECIFICATION

(11) **EP 3 394 979 B1**
(45) Date of publication and mention of the grant of the patent: **18.09.2019**
(21) Application number: 16819487.6
(22) Date of filing: 14.12.2016
(51) Int. Cl.: H02S 50/00

(54) **METHOD AND DEVICE FOR THE DETERMINATION OF A MEASURE OF BAND GAPS AT OPTOELECTRONIC COMPONENTS**
VERFAHREN UND VORRICHTUNG ZUR BESTIMMUNG EINER MESSUNG VON BANDLÜCKEN BEI OPTOELEKTRONISCHEN KOMPONENTEN
PROCÉDÉ ET DISPOSITIF POUR LA DÉTERMINATION D'UNE MESURE DE BANDES INTERDITES AU NIVEAU DE COMPOSANTS OPTOÉLECTRONIQUES

(30) Priority: 23.12.2015 DE 102015226708
(43) Date of publication of application: 31.10.2018
(73) Proprietor: Forschungszentrum Jülich GmbH, 52428 Jülich (DE); Univerza v Ljubljani, 1000 Ljubljana (SI)
(72) Inventor: BOKALIC, Matevz, 1262 Dol pri Ljubljani (SI); TOPIC, Marko, 1000 Ljubljana (SI); PIETERS, Bart Elger, 52428 Jülich (DE); GERBER, Andreas, 50827 Köln (DE); RAU, Uwe, 52428 Jülich (DE)
(74) Representative: Gille Hrabal
(86) International application number: PCT/EP2016/080910
(87) International publication number: WO 2017/108511

(56) References cited:
- JP-A- 2009 054 771
- LOU SHISHU ET AL: "Characterizing different defects in multicrystalline silicon solar cells via modern imaging methods", OPTOMECHATRONIC MICRO/NANO DEVICES AND COMPONENTS III : 8 - 10 OCTOBER 2007, LAUSANNE, SWITZERLAND; [PROCEEDINGS OF SPIE , ISSN 0277-786X], SPIE, BELLINGHAM, WASH, vol. 9563, 23 September 2015 (2015-09-23), pages 95630Y-95630Y, XP060059408, DOI: 10.1117/12.2195811 ISBN: 978-1-62841-730-2

## Description

The invention concerns a method and a device for the determination of a measure of band gaps at optoelectronic components, in particular at solar cells and solar modules.

An optoelectronic component can convert light into an electrical current and vice versa. The document LOU SHISHU ET AL: "Characterizing different defects in multicrystalline silicon solar cells via modern imaging methods",OPTOMECHATRONIC MICRO/NANO DEVICES AND COMPONENTS III : 8 - 10 OCTOBER 2007, LAUSANNE, SWITZERLAND; [PROCEEDINGS OF SPIE , ISSN 0277-786X], SPIE, BELLINGHAM, WASH, vol. 9563, 23 September 2015 (2015-09-23), pages 95630Y-1-95630Y-6, XP060059408, describes techniques to measure the physical parameters of layers for solar cells.

A at optoelectronic components as absorber used semiconductor absorbs light respectively photons, when electrons in the semiconductor are excited by impinging light. Because according to band model, no electrons can be excited in the area of the band gap between valence band and conduction band, the energy of a photon must exceed the energy of the band gap to allow absorption of a photon. The degree of efficiency of an optoelectronic component respectively a solar cell with pn junction therefore depends on among others the band gap of the semiconductor. The determination of band gaps of finished or semi-finished optoelectronic components like CIGS solar cells therefore enables an evaluation of the quality of the component.

A CIGS solar cell is based on the material copper-indium-gallium-diselenide (CIGS). The absorber of a CIGS solar cell comprises a direct band gap, which means the minimum of the conduction band lies directly over the maximum of the valence band. Direct band gaps enable an effective light absorption.

A luminescence method can be applied for the evaluation of the quality of optoelectronic components. At the luminescence method it is utilized that the application of voltage or current on optoelectronic components or a suitable lightening results in a light emission. The light emission can be recorded with a sensor (e.g. with a Si CCD camera). Such recording can be used for an evaluation of the quality of optoelectronic components.

The DE 100 26 162 A1 discloses a method for the quality control of solar modules, according to which under real environmental conditions at the location of use of the respective module two current-voltage characteristic curves are measured at different lightening strengths with same spectrum and two effective characteristic curves are determined thereof. Based on these effective characteristic curves the internal series resistance and from at least one characteristic curve the peak power is determined.

A solar module consists of a plurality of solar cells, which are basically connected in series. If in the following a solar cell is mentioned, then this term also comprises a solar module, as long as not explicitly differentiated between solar cell and solar module.

It is object of the invention to provide a measure for the band gap of an optoelectronic component fast and with low technical effort, which allows an evaluation of the quality of the optoelectronic component.

The problem of the invention is solved by means of a method with the features of the main claim as well as by the objects with the features of the independent claims. Preferable embodiments result from the dependent claims.

The claimed method for providing a measure for a band gap of an optoelectronic component comprises the steps:
- generating a light emission at the optoelectronic component;
- measuring the light emission with at least one sensor with a first and second spectral sensitivity, wherein the first spectral sensitivity differs from the second spectral sensitivity, such that an image 1 and an image 2 is obtained,
- dividing image 1 by image 2, such that a quotient image as measure for the band gap of the absorber of the optoelectronic component is obtained.

Because the band gap of the absorber significantly influences the degree of efficiency of an optoelectronic component, an information about the quality of the optoelectronic component is available by the measure for the band gap. Such a measure is among others of interest for the conduction of quality controls.

When semiconductors consist of several elements, then the band gap is often strongly depending on the stoichiometry. This is the case for CIGS, but also for III-V semiconductors. Due to the manufacturing process, local variations of the stoichiometry and thus bad gap variations can occur. Such a band gap variation decreases the Quality of a solar cell. Such a band gap variation can be made visible by means of the invention with little technical effort. The invention therefore concerns preferably optoelectronic components with a semiconductor, which consists of several elements. In particular, it is a III-V semiconductor. This semiconductor absorbs light respectively photons, when light is intentionally impinging onto the optoelectronic component. Reversely, photons are generated in the semiconductor, thus also light, if intentionally a voltage respectively current is applied at the optoelectronic component.

In one embodiment, the one image is obtained by a Si CCD camera and the other image by a InGaAs camera. The use of the both cameras for recording respectively measuring the light emission ensures suitable spectral sensitivities and namely in particular in the case of a CIGS solar cell. The both cameras are furthermore suitable for optoelectronic components with semiconductors of such kind, which have a comparable luminescence spectrum.

In one embodiment, a measurement of the light emission for obtaining an image by means of a filter in front of the at least one sensor is applied, wherein the filter changes the spectral sensitivity of the light measurement. This allows for example taking a picture with filter and a picture without filter in order to obtain image 1 and image 2. The technical effort is low compared to the use of two different cameras.

The required light emission at the optoelectronic component can be generated by applying an electrical voltage respectively a current by means of a voltage source respectively current source and/or by lightening of the optoelectronic component by means of a light source.

In one embodiment, a voltage amounting to the open clamping voltage or the voltage at the maximum working point respectively a current amounting to the short circuit current or the current at the maximum working point at the optoelectronic component is applied for generating the light emission in order to allow particularly well evaluating the quality of an optoelectronic component.

In one embodiment, the spectral sensitivity of a camera is chosen in a way that it allows photographing the area of wave lengths λ, in which a maximum of the spectral intensity of the luminescence of the semiconductor is expected. Measurement results can thereby be obtained in a further improved manner.

The optoelectronic component is in particular a CIVS solar module.

In one embodiment, the quotient image is converted into a band gap image by means of a calibration curve. This embodiment facilitates ease of evaluation of the quality of the optoelectronic component.

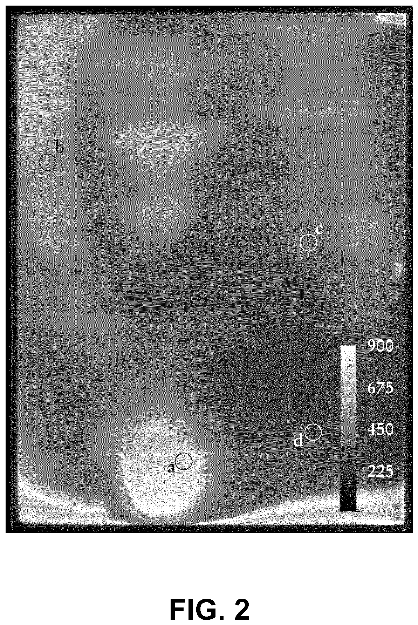

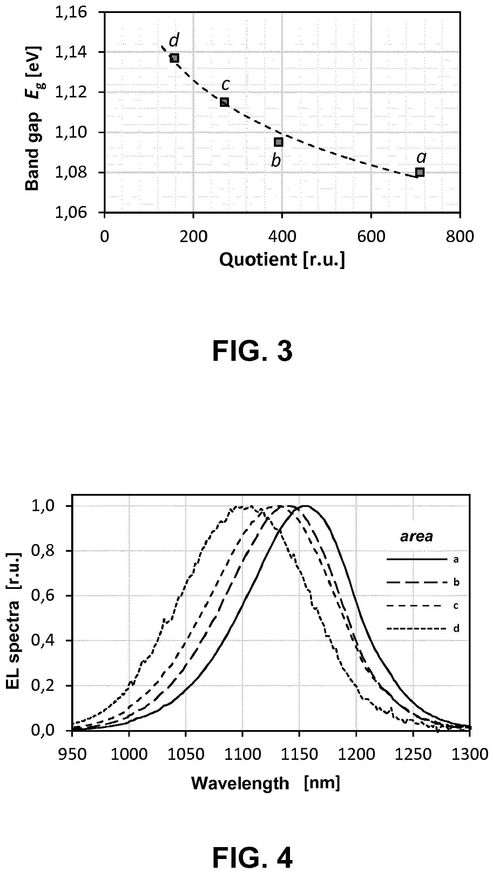

A calibration curve can be determined as following:
First of all, in one embodiment, areas respectively locations on the surface of the solar module are chosen and namely preferably those locations, where values of the quotient image were maximum or minimum or lay close to the maximum or minimum as well as one or more values lying therebetween. In this way, in one example, the locations of a quotient image were chosen, which are referred to a, b, c and d in the figure 2. At the locations that were determined in this way, the electroluminescence spectra are determined by means of spectrometers. Such a result for the locations a, b, c and d is exemplarily shown in the figure 4. Subsequent to that, the positions of the peaks of the thereby determined curves are determined. Doing so, the peak of the curve a, which is related to the location called b, lies for example at a wave length of about 1140 nm. At this location, the value of the quotient image is about 450. By this way, an assignment of locations of the peak maxima to values of the quotient image is obtained thus for example for chosen locations a, b, c, d in the case of the figures 2 and 4. This assignment can be illustrated in table form and/or graphically, and/or a curve or function can be determined by means of curve adaptation. In an example case, a natural logarithm curve was determined in this way. The peak positions of the spectral luminescences represent a measure for the band gaps. The wave lengths at the peak positions are converted into a band gap energy. Thus, the quotient images of the locations a, b, c and d can be assigned in this example case to band gap energies. By means of curve adaptation, a calibration curve can be obtained thereof.

Alternatively, the quantum yield is measured at the chosen locations, thus in the mentioned example at the locations a, b, c and d. The quantum yield QE is the ratio between the number of the per area irradiated (incoming) photons with the wavelength λ and the number of by the irradiation generated electron-hole-pairs, which contribute to the photocurrent density. By means of an adaptation of the increase of the quantum yield close to the absorption edge of the absorber, the band gap Eg is determined in a known way. The band gap values are assigned to the values of the respective quotient image at these areas, which can be illustrated in table form or graphically. Based on this assignment, the searched calibration curve is determined by means of curve adaptation.

In one embodiment, during the production of optoelectronic components, for already sufficiently finished optoelectronic components a respective quotient image is determined and depending on the quotient image or depending on a band gap image, which was generated based on the quotient image, the production of further optoelectronic components is controlled in order to thereby produce in an improved manner.

The invention moreover concerns a computer program product, which causes a computer and at least one to the computer connected light sensor as well as a voltage respectively current source and/or a light source to conduct the following steps, when the computer program product is conducted on the computer:
- generating a voltage respectively current and/or lightening by means of a light source for generating a light emission at an optoelectronic component;
- measuring the light emission with the at least one sensor with a first and second spectral sensitivity, wherein the first spectral sensitivity differs from the second spectral sensitivity, such that an image 1 and an image 2 is obtained,
- dividing image 1 by image 2, such that a quotient image as measure for the band gap of the optoelectronic component is obtained.

The invention furthermore concern a system as recited in claim 11 comprising a computer, at least one light sensor as well as a voltage respectively current source and/or a light source for the generation of light at an optoelectronic component, wherein the system is composed in such a way that it allows conduction of the following steps:
- generating a light emission at the optoelectronic component with the voltage source and/or the light source;
- measuring the light emission with the at least one sensor with a first and second spectral sensitivity, wherein the first spectral sensitivity differs from the second spectral sensitivity, such that an image 1 and an image 2 is obtained,
- dividing image 1 by image 2, such that a quotient image as measure for the band gap of the optoelectronic component is obtained.

According to the present invention, from a solar cell emitted light is thus for example measured with at least one sensor and namely with different spectral sensitivity. In this way, two images called "image 1" and "image 2" are generated. A quotient image is formed between the pixel values of image 1 and of image 2, thus the digital values of the first image are pixelwisely divided by the digital values of the second image. The resulting quotient image is the measure for the quality of the solar cell and thereby allows an evaluation respectively determination of the quality of the solar cell.

The spectral sensitivity of a sensor indicates how high the number of irradiated (incoming) light quanta must be at least at each wave length such that irradiated (incoming) light is recognized. Depending on spectral sensitivity of a sensor (sensor type of a camera), the complete luminescence spectrum can be captured or only portions thereof.

In particular, in one embodiment, material inhomogeneities and defects at a solar cell respectively solar module are determined by means of the quotient image.

It is in particular used a camera with such a high number of pixel, which enables a locally resolved determination of the luminescence emission of the used solar modules. Thereby, material inhomogeneities and defects can be represented in an image in the shortest time.

In one embodiment, two sensors with different spectral sensitivity are required. For an imaging area measurement, a sensor array or a line sensor with a scanning device is commonly used. This is realized in one embodiment by means of two cameras with different sensor types (preferably a Si CCD camera and a InGaAs camera). Additional filers, which influence the spectral path of the both cameras, can additionally advantageously used to obtain further improved results. Alternatively, also a camera (e.g. a InGaAs camera) with one or more suitable filters for limiting the spectral sensitivity of the camera sensor can be used.

For example, an electrical voltage higher than zero is applied at a solar cell, preferably amounting to the open clamping voltage or the voltage at the maximum working point. Alternatively or additionally, the solar cell or one solar module being formed of solar cells can also be lightened by a suitable light source.

The determined quotient image Q can be converted into a band gap and in special cases also in a stoichiometry, i.e. each pixel can then be assigned to a local band gap value or a local stoichiometric ration, such for example a In/Ga ratio in case of CIGS solar cells. This value then indicates, which band gap respectively stoichiometry the corresponding point shaped area on the surface of the solar cell or solar module has, which before was imaged by the cameras.

In order to allow based on the quotient image Q to calculate an easy to evaluate band gap image or eventually also a stoichiometry image, in one embodiment, a calibration curve is determined, which shows the correlation between the quotient Q in relation to the band gap E_{g}. This allows a transformation of the quotient image Q into a band gap image respectively stoichiometry image.

The method is preferably applied for:
(1) Quality control of solar cells and solar modules, specifically close to production automated methods.
(2) Process control of solar cells and solar modules, specifically close to production automated methods.

In the following, the invention is illustrated in more detail based on examples.
- Figure 1:: Electroluminescence image of a CIGS module recorded with different cameras. Left: measured with a silicon camera (B2). Right: measured with a InGaAs camera (B1).
- Figure 2:: Quotient image calculated based on the both electroluminescence images of figure 1 by means of pixelwise calculation of the ratio of the electroluminescence images B1 (InGaAs camera) and B2 (Si CCD camera). The marked locations (a, b, c, d) show areas, which were used for the determination of the calibration curve.
- Figure 3:: Calibration curve for converting digital pixel values of the quotient image into a band gap image. The measurement points correspond to the marked areas of figure 2. At these positions, the local band gap was determined before.
- Figure 4:: Normalized electroluminescence spectra measured at the marked module areas of figure 2.
- Figure 5:: Lateral band gap image of the CIGS module. The image was pixelwisely calculated from the quotient image (figure 2) under consideration of the calibration curve (figure 3).

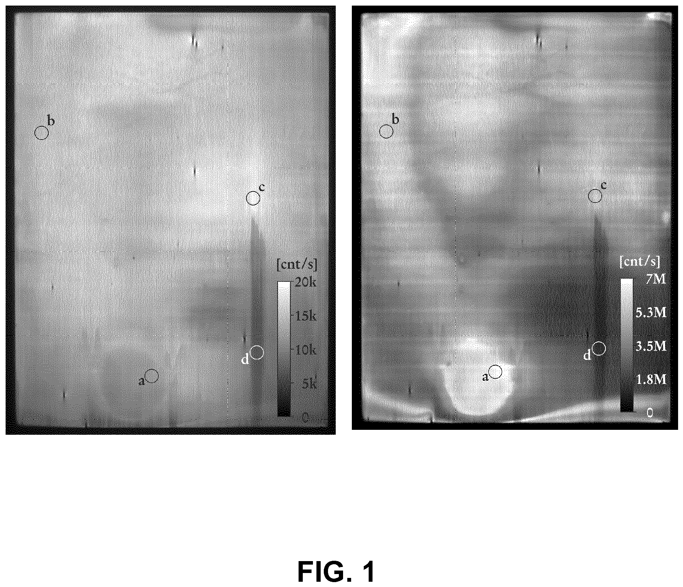

For the determination of a band gap image of a CIGS module, in one exemplary embodiment, the luminescence image was recorded with two cameras of different spectral sensitivity and namely a silicon CCD and a InGaAs camera while applying a positive electrical voltage. Attention was payed to equal resolution and orientation of the both luminescence images. Figure 1 shows two thereby obtained luminescence images of a CIGS module that was recorded with a silicon CCD camera (B1) and a InGaAs camera (B2).

In a next step, a quotient image was pixelwisely calculated (B2/B1) based on both single images. If the camera resolutions are not equal, a record respectively a image can be scaled and by this way adapted to the record, thus to the image, of the other camera in order to generate a quotient image for all pixels. The result is shown in figure 2. In order to calculate a band gap image (stoichiometry image) from the quotient image, a calibration curve is needed. Figure 3 shows the therefor used calibration curve, which was determined by determination of the band gaps at different points of the module (marked areas a, b, c, d).

Figure 4 shows the electroluminescence spectra of the marked areas a, b, c, d, which were recorded with a spectrometer. These show a noticeable shift of the spectral intensities EL (electroluminescence), which is equivalent to a band gap change. From these electroluminescence spectra, band gap energies were determined as described. The figure 4 illustrates that the four shown spectral intensities have a maximum in an area of wavelength λ, which lies about between 110 and 1170 nm. The spectral sensitivity of the used cameras eventually under the use of filters is now adventurously adjusted to the wavelength range that is expected for this case of CIGS solar cells. In this way, a Si CCD camera covers a wavelength range up to ca. 1100 nm and can therefore capture at least an with the wavelength rising increase of the spectral intensity. In case of the area d, also the peak maximum is captured (covered). An InGaAs camera captures the entire wavelength range shown in figure 4.

Because with a camera an integral of a spectral sensitivity is captured in difference to a spectrometer, two images at different spectral sensitivities are recorded in order to thereby allow providing a measure for a band gap.

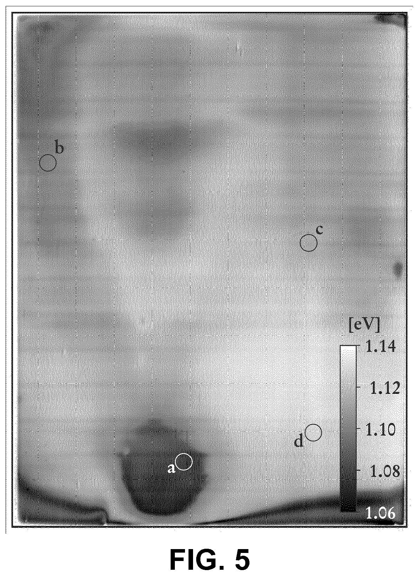

Figure 5 shows the band gap image that was pixelwisely calculated from the quotient image Q and the calibration curve. Figure 5 illustrates that the band gaps lie between 1,07 eV to 1,15 eV.

Thanks to the invention, a fast camera based and thus technical particularly simple method is made available for determination of the band gap respectively stoichiometry for optoelectronic components like CIGS solar module (or a CIGS solar cell or any circuit configuration of CIGS solar cells or CIGS solar modules) under use of two different camera types or a camera with additional filer. The values of the quotient image can be transformed pixelwisely into a band gap image or in special cases also in a stoichiometry image (ratio In to Ga).

For the generation of a light emission, an applied positive electrical voltage respectively current or a lightening with constant light intensity can be applied.

A contactless determination of band gap variations (stoichiometry variations) in CIGS solar modules (CIGS solar cells) in an early stage of the production process is enabled.

One further embodiment - particularly related to one of the preceding embodiments, particularly of the method aspect of the invention - is characterized in that the light emission is generated by applying an electrical voltage by means of a voltage source at the optoelectronic component and/or a current by means of a current source at the optoelectronic component, respectively, and/or by lightening of the optoelectronic component by means of a light source.

One further embodiment - particularly related to one of the preceding embodiments, particularly of the method aspect of the invention - is characterized in that a voltage amounting to the open clamping voltage or the voltage at the maximum working point at the optoelectronic component and/or a current amounting to the short circuit current or the current at the maximum working point at the optoelectronic component, respectively, is applied for generating the light emission.

One further aspect of the invention - particularly combinable to one of the preceding embodiments, particularly in analogy to one of the preceding aspects of the invention - concerns a computer program product, which causes a computer and at least one to the computer connected light sensor as well as a voltage and/or current source, respectively, and/or a light source to conduct the following steps:
- generating a light emission at an optoelectronic component;
- measuring the light emission with the at least one sensor with a first and second spectral sensitivity, wherein the first spectral sensitivity differs from the second spectral sensitivity, such that an image 1 and an image 2 is obtained,
- dividing image 1 by image 2, such that a quotient image as measure for the band gap of the optoelectronic component is obtained.

One further aspect of the invention - particularly combinable to one of the preceding embodiments, particularly in analogy to one of the preceding aspects of the invention - concerns a system comprising a computer, at least one light sensor as well as a voltage and/or current source, respectively, and/or a light source for the generation of light at an optoelectronic component, wherein the system is composed in such a way that it allows conduction of the following steps:
- generating a light emission at the optoelectronic component with the voltage respectively current source and/or the light source;
- measuring the light emission with the at least one sensor with a first and second spectral sensitivity, wherein the first spectral sensitivity differs from the second spectral sensitivity, such that an image 1 and an image 2 is obtained,
- dividing image 1 by image 2, such that a quotient image as measure for the band gap of the optoelectronic component is obtained.

## Claims

1. Method for providing a measure for a band gap of an optoelectronic component with the steps:
- generating a light emission at the optoelectronic component;
- measuring the light emission with at least one sensor with a first and second spectral sensitivity, wherein the first spectral sensitivity differs from the second spectral sensitivity, such that an image 1 and an image 2 is obtained,
- dividing image 1 by image 2, such that a quotient image as measure for the band gap of the absorber of the optoelectronic component is obtained.

2. Method of claim 1, **characterized in that** the one image is obtained by a Si CCD camera and the other image by a InGaAs camera.

3. Method of one of the preceding claims, **characterized in that** a measurement of the light emission for obtaining an image by means of a filter in front of the at least one sensor is applied, wherein the filter changes the spectral sensitivity of the light measurement.

4. Method of one of the preceding claims, **characterized in that** the light emission is generated by applying an electrical voltage by means of a voltage source respectively a current by means of a current source at the optoelectronic component and/or by lighting of the optoelectronic component by means of a light source.

5. Method of the preceding claim, **characterized in that** a voltage amounting to the open clamping voltage or the voltage at the maximum working point respectively a current amounting to the short circuit current or the current at the maximum working point at the optoelectronic component is applied for generating the light emission.

6. Method of one of the preceding claims, **characterized in that** the optoelectronic component comprises an absorber with a direct band gap and in particular is a CIGS solar module.

7. Method of one of the preceding claims, **characterized in that** the quotient image is converted into a band gap image by means of a calibration curve.

8. Method of one of the preceding claims, **characterized in that** during the production of optoelectronic components, for already sufficiently finished optoelectronic components the respective quotient image is determined and depending on the quotient image or depending on a band gap image, which was generated based on the quotient image, the production of further optoelectronic components is controlled.

9. Method of one of the preceding claims, **characterized in that** by means of the quotient image or by means of a band gap image, which was generated based on the quotient image, the quality of an optoelectronic component is evaluated.

10. Computer program product, which causes a computer and at least one to the computer connected light sensor as well as a voltage respectively current source and/or a light source to conduct the following steps:
- generating a light emission at an optoelectronic component;
- measuring the light emission with the at least one sensor with a first and second spectral sensitivity, wherein the first spectral sensitivity differs from the second spectral sensitivity, such that an image 1 and an image 2 is obtained,
- dividing image 1 by image 2, such that a quotient image as measure for the band gap of the optoelectronic component is obtained.

11. System comprising a computer, a computer program product as recited in claim 10, at least one light sensor as well as a voltage respectively current source and/or a light source for the generation of light at an optoelectronic component, wherein the system is composed in such a way that it allows conduction of the following steps:
- generating a light emission at the optoelectronic component with the voltage respectively current source and/or the light source;
- measuring the light emission with the at least one sensor with a first and second spectral sensitivity, wherein the first spectral sensitivity differs from the second spectral sensitivity, such that an image 1 and an image 2 is obtained,
- dividing image 1 by image 2, such that a quotient image as measure for the band gap of the optoelectronic component is obtained.

## Patentansprüche

1. Verfahren zur Bereitstellung einer Messung für eine Bandlücke eines optoelektronischen Bauteils mit den Schritten:
- Erzeugen einer Lichtemission an dem optoelektronischen Bauteil;
- Messen der Lichtemission mit mindestens einem Sensor mit einer ersten und zweiten spektralen Empfindlichkeit, wobei sich die erste spektrale Empfindlichkeit von der zweiten spektralen Empfindlichkeit unterscheidet, so dass ein Bild 1 und ein Bild 2 erhalten wird,
- Teilen von Bild 1 durch Bild 2, so dass ein Quotientenbild als Messung für die Bandlücke des Absorbers des optoelektronischen Bauteils erhalten wird.

2. Verfahren nach Anspruch 1, **dadurch gekennzeichnet, dass** das eine Bild durch eine Si-CCD-Kamera und das andere Bild durch eine InGaAs-Kamera erhalten wird.

3. Verfahren nach einem der vorstehenden Ansprüche, **dadurch gekennzeichnet, dass** eine Messung der Lichtemission zur Erhaltung eines Bildes mit Hilfe eines Filters vor mindestens einem Sensor angewendet wird, wobei der Filter die spektrale Empfindlichkeit der Lichtmessung ändert.

4. Verfahren nach einem der vorstehenden Ansprüche, **dadurch gekennzeichnet, dass** die Lichtemission durch Anlegen einer elektrischen Spannung mit Hilfe einer Spannungsquelle beziehungsweise eines Stroms mit Hilfe einer Stromquelle an dem optoelektronischen Bauteil und/oder durch Beleuchtung des optoelektronischen Bauteils mit Hilfe einer Lichtquelle erzeugt wird.

5. Verfahren nach dem vorstehenden Anspruch, **dadurch gekennzeichnet, dass** eine Spannung in Höhe der offenen Klemmspannung oder der Spannung am maximalen Arbeitspunkt beziehungsweise ein Strom in Höhe des Kurzschlussstroms oder der Strom an dem maximalen Arbeitspunkt an dem optoelektronischen Bauteil zur Erzeugung der Lichtemission angelegt wird.

6. Verfahren nach einem der vorstehenden Ansprüche, **dadurch gekennzeichnet, dass** das optoelektronische Bauteil einen Absorber mit einer direkten Bandlücke umfasst und insbesondere ein CIGS-Solarmodul ist.

7. Verfahren nach einem der vorstehenden Ansprüche, **dadurch gekennzeichnet, dass** das Quotientenbild mit Hilfe einer Kalibrierkurve in ein Bandlückenbild umgewandelt wird.

8. Verfahren nach einem der vorstehenden Ansprüche, **dadurch gekennzeichnet, dass** während der Herstellung von optoelektronischen Bauteilen, für bereits ausreichend fertiggestellte optoelektronische Bauteile das entsprechende Quotientenbild bestimmt wird und abhängig von dem Quotientenbild oder abhängig von einem Bandlückenbild, das basierend auf dem Quotientenbild erzeugt wurde, die Herstellung von weiteren optoelektronischen Bauteilen gesteuert wird.

9. Verfahren nach einem der vorstehenden Ansprüche, **dadurch gekennzeichnet, dass** mit Hilfe des Quotientenbildes oder mit Hilfe eines Bandlückenbildes, das basierend auf dem Quotientenbild erzeugt wurde, die Qualität von einem optoelektronischen Bauteil ausgewertet wird.

10. Computerprogrammprodukt, welches einen Computer und mindestens einen mit dem Computer verbundenen Lichtsensor sowie eine Spannungs- beziehungsweise Stromquelle und/oder eine Lichtquelle veranlasst, die folgenden Schritte durchzuführen:
- Erzeugen einer Lichtemission an dem optoelektronischen Bauteil;
- Messen der Lichtemission mit mindestens einem Sensor mit einer ersten und zweiten spektralen Empfindlichkeit, wobei sich die erste spektrale Empfindlichkeit von der zweiten spektralen Empfindlichkeit unterscheidet, so dass ein Bild 1 und ein Bild 2 erhalten wird,
- Teilen von Bild 1 durch Bild 2, so dass ein Quotientenbild als Messung für die Bandlücke des optoelektronischen Bauteils erhalten wird.

11. System umfassend einen Computer, ein Computerprogrammprodukt wie in Anspruch 10 beschrieben, mindestens einen Lichtsensor sowie eine Spannungsbeziehungsweise eine Stromquelle und/oder eine Lichtquelle für die Erzeugung von Licht an einem optoelektronischen Bauteil, wobei das System so aufgebaut ist, dass es die Durchführung der folgenden Schritte ermöglicht:
- Erzeugen einer Lichtemission an dem optoelektronischen Bauteil mit der Spannungsbeziehungsweise Stromquelle und/oder der Lichtquelle;
- Messen der Lichtemission mit mindestens einem Sensor mit einer ersten und zweiten spektralen Empfindlichkeit, wobei sich die erste spektrale Empfindlichkeit von der zweiten spektralen Empfindlichkeit unterscheidet, so dass ein Bild 1 und ein Bild 2 erhalten wird,
- Teilen von Bild 1 durch Bild 2, so dass ein Quotientenbild als Messung für die Bandlücke des optoelektronischen Bauteils erhalten wird.

## Revendications

1. Procédé pour procurer une mesure pour une bande interdite d'un composant optoélectronique avec les étapes consistant à :
- générer une émission de lumière au niveau du composant optoélectronique ;
- mesurer l'émission de lumière avec au moins un capteur ayant une première et une seconde sensibilité spectrale, la première sensibilité spectrale étant différente de la seconde sensibilité spectrale, de sorte qu'une image 1 et une image 2 sont obtenues,
- diviser l'image 1 par l'image 2, de sorte qu'une image de quotient est obtenue comme mesure pour la bande interdite de l'absorbeur du composant optoélectronique.

2. Procédé selon la revendication 1, **caractérisé en ce que** l'une des images est obtenue par une caméra Si-CCD et l'autre image par une caméra InGaAs.

3. Procédé selon l'une des revendications précédentes, **caractérisé en ce que** une mesure de l'émission de lumière est appliquée pour obtenir une image au moyen d'un filtre devant le au moins un capteur, le filtre modifiant la sensibilité spectrale de la mesure lumineuse.

4. Procédé selon l'une des revendications précédentes, **caractérisé en ce que** l'émission de lumière est générée par application d'une tension électrique au moyen d'une source de tension ou d'un courant au moyen d'une source de courant, respectivement, au niveau du composant optoélectronique et/ou par éclairage du composant optoélectronique au moyen d'une source de lumière.

5. Procédé de la revendication précédente, **caractérisé en ce qu'**une tension correspondant à la tension de serrage ouverte ou à la tension au point de fonctionnement maximal, respectivement un courant correspondant au courant de court-circuit ou au courant au point de fonctionnement maximal au niveau du composant optoélectronique est appliqué pour générer l'émission de lumière.

6. Procédé de l'une des revendications précédentes, **caractérisé en ce que** le composant optoélectronique comprend un absorbeur ayant une bande interdite directe et en particulier est un module solaire CIGS.

7. Procédé de l'une des revendications précédentes, **caractérisé en ce que** l'image du quotient est convertie en une image de bande interdite au moyen d'une courbe d'étalonnage.

8. Procédé de l'une des revendications précédentes, **caractérisé en ce que** lors de la fabrication de composants optoélectroniques, pour des composants optoélectroniques déjà suffisamment finis, l'image de quotient respective est déterminée, et en fonction de l'image de quotient ou d'une image de bande interdite qui a été produite sur la base de l'image de quotient, la production de composants optoélectroniques supplémentaires est commandée.

9. Procédé de l'une des revendications précédentes, **caractérisé en ce que**, au moyen de l'image de quotient ou d'une image de bande interdite qui a été générée sur la base de l'image de quotient, la qualité d'un composant optoélectronique est évaluée.

10. Produit de programme d'ordinateur, qui amène un ordinateur et au moins un au capteur de lumière connecté à l'ordinateur ainsi qu'à une source de tension respectivement de courant et/ou une source de lumière à effectuer les étapes suivantes :
- la génération d'une émission de lumière au niveau d'un composant optoélectronique ;
- la mesure de l'émission de lumière avec le au moins un capteur présentant une première et une seconde sensibilité spectrale, la première sensibilité spectrale étant différente de la seconde sensibilité spectrale, de sorte qu'une image 1 et une image 2 est obtenue,
- la division de l'image 1 par l'image 2, de sorte qu'une image quotient est obtenue comme mesure pour la bande interdite du composant optoélectronique.

11. Système comprenant un ordinateur, un produit de programme informatique tel que décrit dans la revendication 10,
au moins un capteur de lumière ainsi qu'une source de tension respectivement source de courant et/ou source de lumière pour la génération de lumière au niveau d'un composant optoélectronique, dans laquelle le système est composé de telle manière qu'il permet la réalisation des étapes suivantes :
- la génération d'une émission de lumière au niveau du composant optoélectronique avec la source de tension respectivement de courant et/ou la source de lumière ;
- la mesure de l'émission de lumière avec le au moins un capteur présentant une première et une seconde sensibilité spectrale, la première sensibilité spectrale étant différente de la seconde sensibilité spectrale, de sorte qu'une image 1 et une image 2 sont obtenues,
- la division de l'image 1 par l'image 2, de sorte qu'une image quotient est obtenue comme mesure pour la bande interdite du composant optoélectronique.
